Europäisches Patentamt

European Patent Office

Office européen des brevets

(11) Veröffentlichungsnummer: **0 360 905**
A1

(12) **EUROPÄISCHE PATENTANMELDUNG**

(21) Anmeldenummer: 88116126.9

(22) Anmeldetag: 29.09.88

(51) Int. Cl.⁵: **H05K 9/00** , E04B 1/68

(43) Veröffentlichungstag der Anmeldung:
04.04.90 Patentblatt 90/14

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Tiefholz, Joachim**
**Aehrenweg 8B**
**D-8056 Neufahrn(DE)**

(54) **Dehnungsfuge.**

(57) Eine Dehnungsfuge (1) aus einem geschlossenen Metallblech besitzt ein Faltungssystem in den
drei Raumdimensionen. Dieses Faltungssystem wird
beispielsweise durch eine Doppel-Zick-Zack-Faltung
gebildet, wobei vorzugsweise die zwei durch die
Faltenrichtungen gebildeten Ebenen im wesentlichen
senkrecht aufeinanderstehen. Die erste Zick-Zack-
Faltung wird dabei durch Falten (3) und die zweiten
durch weitere Falten (4, 6, 8) gebildet. Die Dehnungsfuge (1) ist mit Flanschen (2) fugendicht miteinander verbunden.

FIG 1

EP 0 360 905 A1

# Dehnungsfuge

Die Erfindung betrifft eine Dehnungsfuge aus geschlossenem Metallblech.

Derartige Dehnungsfugen sind erforderlich, wenn Bauteile überbrückt werden sollen, die Querbewegungen gegeneinander ausführen können. Beispielsweise erfolgt die Schirmung von Räumen durch Auskleiden mit Metallfolien bzw. Blechen, die bahnweise auf Wände, Decke und Fußboden verlegt oder geklebt und fugendicht zusammengelötet werden. Ist nun das Gebäude z.B. in Stahlbetonbauweise errichtet, besteht die Gefahr, daß einzelne Betonplatten Querbewegungen gegeneinander ausführen können, wobei diese Bewegungen im Prinzip in allen drei Raumrichtungen erfolgen können (z.B. Wärmeausdehnungen, Gebäudeabsenkungen). An diesen Stelle würde nun durch die entstehenden Scherbewegungen das zur Schirmung verwendete Material aufreißen und so das unerwünschte Eindringen von hochfrequenten Wechselfeldern in den geschirmten Raum ermöglichen.

Zur Behebung dieser Schwierigkeit wurde bisher eine Fugenausbildung gewählt, die eine Omega-förmig ausgebildete Blechschlaufe vorsieht. Querbewegungen zweier aneinander angrenzender Bauteile können allerdings bei dieser Fugenausbildung nur in begrenztem Maß abgefangen werden. Schließen die durch die Dehnungsfuge zu überbrückenden Bauteile einen Raumwinkel ein, indem sie sich beispielsweise von der Wand in die Decke erstrecken, ist eine ordnungsgemäß funktionierende Dehnungsfugenausbildung überhaupt nicht mehr gewährleistet, da jede Bewegung im Fugenprofil in der Ecke besondere Spannungen erzeugt. Da gerade im Knick eine Lötfuge unumgänglich ist, ist dieser Bereich besonders bruchgefährdet, weil aus der Geometrie heraus die erforderliche Elastizität nicht gewährleistet ist.

Aufgabe der Erfindung ist es, eine Dehnungsfuge aus geschlossenem Metallblech anzugeben, bei der die aufgezeigten Schwierigkeiten nicht auftreten.

Diese Aufgabe wird erfindungsgemäß dadurch gelöst, daß das Metallblech ein in den drei Raumdimensionen dehnbares Faltensystem besitzt.

Hiermit wird der Vorteil erzielt, daß die Dehnungsfuge in jeder Bewegungsrichtung elastisch ist und somit auch die besonders kritische Querverschiebung zweier Bauteile in einer Fuge elastisch gewährleistet.

Vorteilhafterweise besitzt die Metallfolie eine Doppel-Zick-Zack-Faltung, wobei die zwei durch die Faltenrichtungen gebildeten Ebenen zweckmäßig im wesentlichen senkrecht aufeinanderstehen.

Gemäß einer Weiterbildung der Erfindung ist die Zick-Zack-Faltung des Metallblechs im Bereich einer zu überbrückenden Raumecke spiegelbildlich gedreht. Damit wird der Vorteil erzielt, daß eine Winkelfaltung ohne Lötfuge das Faltensystem der Längsseite über Eck fortsetzt, wodurch die systemeigene Elastizität und Stabilität unverändert erhalten bleiben. Dies bedeutet, daß im Winkelprofil die Richtung des Längsprofiles umgedreht wird. Damit nicht zwei verschiedene Winkelprofile nötig sind, um das Fugenprofil vollständig um die vier Ecken eines Raumes herumzuführen, ist es zweckmäßig, die Breite des Fugenprofiles nach folgender Formel auszuwählen:

$$B = I_1(n + 1/2),$$

wobei

B die Breite des Profils,
$I_1$ das Intervall 1 des Faltensystems und n eine ganze Zahl größer Null bedeuten.

Die Vorteile des Gegenstandes der Erfindung werden im folgenden anhand von Ausführungsbeispielen näher erläutert.

In der dazugehörenden Zeichnung zeigen

FIG 1 eine perspektivische Ansicht einer gefalteten Dehnungsfuge,

FIG 2 ein Längs- und Winkelprofil in Aufsicht und Abwicklung,

FIG 3 einen Querschnitt gemäß FIG 2 und

FIG 4 einen Längsschnitt gemäß FIG 2.

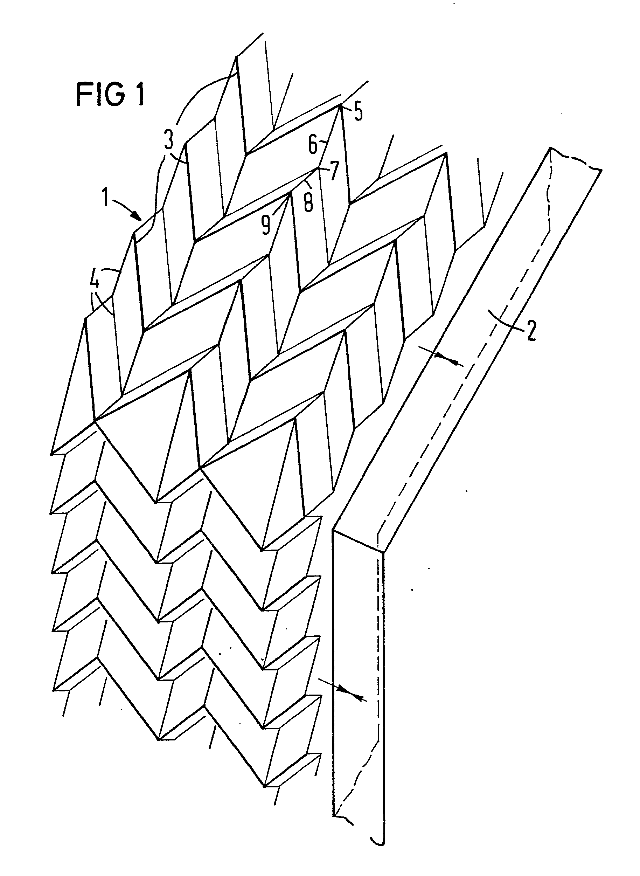

In der FIG 1 ist in perspektivischer Ansicht eine Dehnungsfuge 1 aus einem gefalteten Metallblech dargestellt, wobei die Dehnungsfuge über eine Raumecke gefaltet ist. Die Dehnungsfuge 1 wird seitlich an zwei Flanschen fugendicht angelötet bzw. angeschweißt, von denen in der FIG 1 nur ein Flansch 2 dargestellt ist. In der FIG 1 befinden sich die stärker ausgezogenen Linien in der Zeichenebene, während die schwächer ausgezogenen Linien 4 unterhalb der Zeichenlinie angeordnet sind. Die dargestellte Doppel-Zick-Zack-Faltenanordnung ergibt sich dadurch, daß eine Zick-Zack-Linie durch die stark ausgezogenen Kanten 3 gebildet sind, während die zweite Zick-Zack-Anordnung dadurch gebildet wird, daß beispielsweise von einem Punkt 5 in der Zeichenebene ausgehend eine Faltung 6 zu einem Punkt 7 unterhalb der Zeichenebene abfällt und eine Faltung 8 zu einem Punkt 9 in der Zeichenebene ansteigt, was sich periodisch fortsetzt.

Durch diese Ausbildung wird gewährleistet, daß die Dehnungsfuge 1 in allen drei Raumrichtungen Bewegungen gegeneinander elastisch aufnehmen kann.

In der FIG 2 ist in Draufsicht D und Abwicklung A eine Dehnungsfuge dargestellt, die aus Längsprofilen L und Winkelprofilen W zusammengesetzt ist. Dabei ist die eine durch die stark ausgezogenen Linien dargestellte Zick-Zack-Faltung in der Zeichenebene angeordnet, während die durch die schwach ausgezogenen Linien dargestellte zweite Zick-Zack-Anordnung unterhalb der Zeichenebene verläuft.

Die Amplituden der beiden Zick-Zack-Faltungen sind mit $l_1$ bzw. $l_2$ bezeichnet, und die Dehnungsfuge weist die Breite B auf. An der oberen Seite der Dehnungsfuge ist der Flansch 2 angeordnet.

Aus der FIG 2 ist weiterhin zu entnehmen, daß die Breite B zur Amplitudenbreite $l_1$ in folgendem Verhältnis steht:
B = $l_1$ (n + 1/2),
wobei n in der FIG 2 1 ist.

Bei der Ausrichtung der Fugenprofilbreite B nach dieser Formel entsteht ein einziges, aber unsymmetrisches Winkelprofil W, das dann, entsprechend gedreht, für alle Raumwinkel gleichermaßen verwendet werden kann. Hierbei ist zu berücksichtigen, daß die Ansicht des Winkelprofiles W in der FIG 2 nur so dargestellt werden kann, daß die eine Hälfte als Draufsicht D und die andere als Abwicklung A gezeichnet ist.

Entsprechend dem Flansch 2 auf der Oberseite wird auch auf der Unterseite des Fugenprofils ein weiterer gewinkelter Flansch fugendicht angebracht (geschweißt, geschraubt oder gelötet). Diese Flansche werden dann z.B. mit der Blechschirmung eines geschirmten Raumes fugendicht verbunden.

Da die Gesamtlänge einer Fugenabdeckung ein ganzes Vielfaches der Amplitude $l_2$ ist, ist im allgemeinen die Anpassung der Fugenlänge an den Bau umso genauer, je kleiner diese Intervallänge $l_2$ gewählt wird. Für eine präzise Anpassung kann es erforderlich werden, das Fugenprofil nach der Herstellung entsprechend zu strecken.

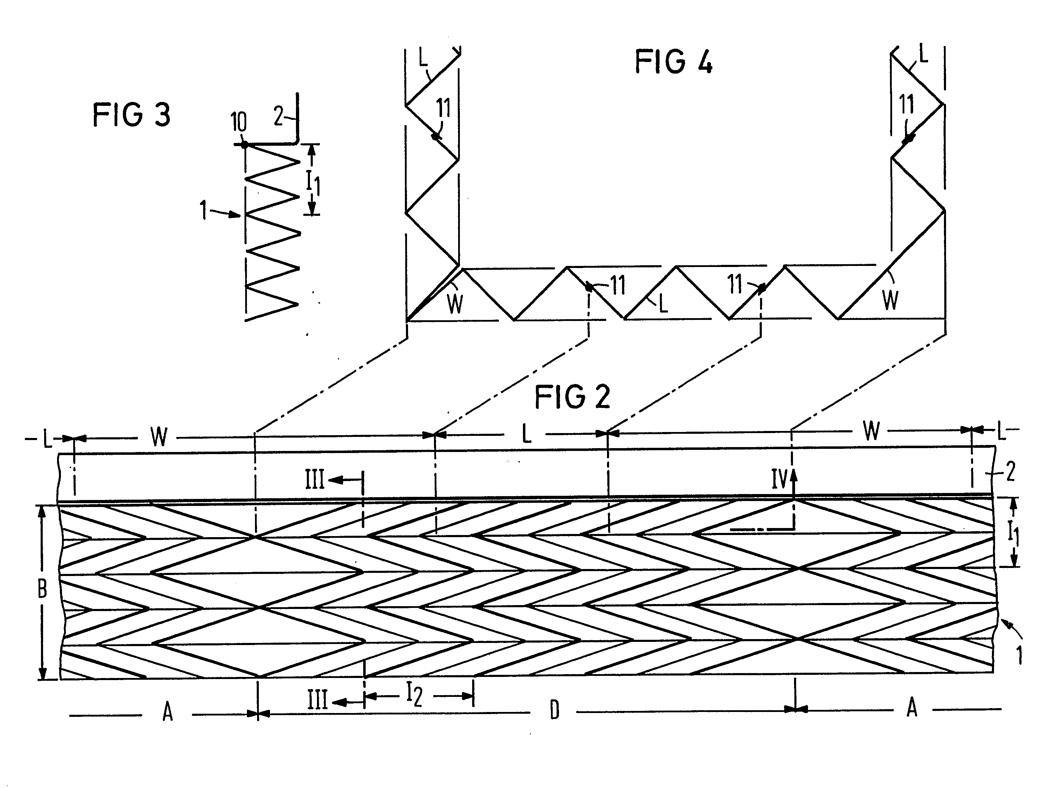

In der FIG 3 ist ein Querschnitt gemäß III nach FIG 2 dargestellt, woraus ersichtlich ist, daß das Fugenprofil 1 mit dem Flansch 2 durch beispielsweise eine Schweiß- oder Lötnaht 10 verbunden ist.

In der FIG 4 ist ein Längsschnitt gemäß IV nach FIG 2 dargestellt, aus der die Faltung über zwei Raumwinkel hervorgeht. Ein Längsprofil L ist zur Faltung um zwei Raumecken mit zwei Winkelprofilen verbunden, die auf der anderen Seite wiederum mit zwei Längsprofilen L verbunden sind. Die einzelnen Profile L bzw. W sind an den Stellen 11 mittels Löt- oder Schweißnähten fugen dicht miteinander verbunden.

Das erfindungsgemäße Faltensystem ist in beliebiger Größe herstellbar bis hin zur geschlossenen Blechwand oder als elastischer Blechkragen um einen Dübel herum, wodurch im Bedarfsfalle auch größere Bewegungen getrennter Bauteile durch entsprechend groß gewählte Profilflächen aufgefangen werden können.

## Ansprüche

1. Dehnungsfuge aus geschlossenem Metallblech, **dadurch gekennzeichnet,** daß das Metallblech ein in den drei Raumdimensionen dehnbares Faltensystem besitzt.

2. Dehnungsfuge nach Anspruch 1, **dadurch gekennzeichnet,** daß das Metallblech eine Doppel-Zick-Zack-Faltung besitzt.

3. Dehnungsfuge nach Anspruch 2, **dadurch gekennzeichnet,** daß die zwei durch die Faltenrichtungen gebildeten Ebenen im wesentlichen senkrecht aufeinanderstehen.

4. Dehnungsfuge nach Anspruch 2 oder 3, **dadurch gekennzeichnet,** daß die Zick-Zack-Faltung des Metallblechs im Bereich einer zu überbrückenden Raumecke spiegelbildlich gedreht ist, so daß in der Raumecke keine Schweiß- bzw. Lötnaht erforderlich ist.

5. Dehnungsfuge nach zumindest einem der Ansprüche 1 bis 4, **dadurch gekennzeichnet,** daß die Breite B des Fugenprofils für die wahlweise Benutzung von nur einem Winkelprofiltyp in allen Raumecken durch die Formel:
B = $l_1$(n + 1/2)
festgelegt ist, wobei
$l_1$ die Amplitude der ersten Zick-Zack-Faltung und n eine ganze Zahl größer Null ist.

88 P 16805

FIG 1

FIG 4

FIG 3

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4 ) |
|---|---|---|---|
| X | US-A-3395505 (J.E. LAMY) <br> * Spalte 1, Zeile 25 - Spalte 2, Zeile 24; Figuren 1-5 * | 1 | H05K9/00 <br> E04B1/68 |
| A | | 2-3 | |
| | --- | | |
| A | EP-A-0214886 (THOMSON-CSF) <br> * Spalte 3, Zeile 56 - Seite 64 * | 2-3 | |
| | --- | | |
| A | US-A-2103337 (J.F. OURY) <br> * Spalte 2, Zeile 17 - Zeile 41 * | 1 | |
| | ----- | | |

|  |
|---|
| **RECHERCHIERTE SACHGEBIETE (Int. Cl.4 )** |
| · E04B <br> H05K |

Der vorliegende Recherchenbericht wurde für alle Patentansprüche erstellt

| Recherchenort | Abschlußdatum der Recherche | Prüfer |
|---|---|---|
| DEN HAAG | 01 JUNI 1989 | TOUSSAINT F.M.A. |

EPO FORM 1503 03.82 (P0403)